# EUROPEAN PATENT SPECIFICATION

(11) **EP 2 511 764 B1**
(45) Date of publication and mention of the grant of the patent: **01.04.2020**
(21) Application number: 12175894.0
(22) Date of filing: 24.02.2009
(51) Int. Cl.: G03F 1/00, G03F 1/74, H01J 37/305, H01J 37/304, C23C 16/04

(54) **Method for processing an object with miniaturized structures**
Verfahren zur Verarbeitung eines Objekts mit miniaturisierten Strukturen
Procédé de traitement d'un objet comportant des structures miniaturisées

(30) Priority: 28.02.2008 DE 102008011530; 28.02.2008 DE 102008011531
(43) Date of publication of application: 17.10.2012
(62) Divisional of application: 09715092.4
(73) Proprietor: Carl Zeiss SMT GmbH, 73447 Oberkochen (DE)
(72) Inventor: Budach, Michael, 63456 Hanau (DE); Bret, Tristan, 64287 Darmstadt (DE); Edinger, Klaus, 64653 Lorsch (DE); Hofmann, Thorsten, 63110 Rodgau (DE)
(74) Representative: Müller, Utz

(56) References cited:
- WO-A1-03/012551
- DE-A1- 10 261 035
- US-A- 6 028 953
- US-B1- 6 544 692

## Description

The present invention relates to a method for processing an object with miniaturized structures, in particular for repairing masks that are used in semiconductor fabrication, or for processing semiconductor circuits.

Electron microscopy is a long established method for inspecting a surface of an object to be tested. In scanning electron microscopy, the surface of the object to be tested is scanned by means of a fine electron beam. The electrons emitted by the object as a consequence of the striking of the electron beam and/or electrons backscattered at the object are detected in order to compose an electron image of the scanned region.

Electron microscopes usually have the following components: an electron beam source for producing an electron beam, an electron optics for focusing the electron beam onto the object to be tested, a deflecting optics for scanning the surface of the object with the electron beam, and at least one detector for detecting electrons backscattered at the object surface or emerging therefrom.

In addition to the pure inspection, electron microscopes are also increasingly being used to process miniaturized structures on an object and/or to produce an object with miniaturized structures. In this case, material is deposited or removed selectively and with high precision by feeding to a site to be processed on the object a reaction gas that is excited by the electron beam striking the site to be processed on the object and becomes chemically reactive. In this way it is possible to deposit material at a selected location or to remove material from the object at selected locations. In this procedure, the reaction gas is suitably selected as a function of the material, which is to be removed, of a miniaturized structure on a surface of the object, or as a function of the material to be deposited.

A particular field of application of this technique is to be found in the field of mask repair for lithography. Masks continue to play a prominent roll in the production of miniaturized structures in the semiconductor industry sector. In the course of lithography, the (photo) mask is transradiated, and there is produced on a wafer a reduced image of the mask that exposes a photoresist applied to the wafer, and thus defines on the wafer structures to be produced in subsequent processing steps. Masking defects can consequently have a pronounced disadvantageous effect on the quality of the miniaturized structures produced with their aid. Since the mask production continues to be time consuming and costly, mask repair methods are being applied more and more. In this case, defects in the mask can be repaired very specifically and with high precision by means of the chemical reaction described and induced by the electron beam.

In a mask repair method, and also in the case of other methods for producing miniaturized structures, it is necessary to detect an end point of the deposition or removal of material at which sufficient material has been deposited or removed. Diverse parameters can be used for the purpose of detecting this, for example signals of secondary or backscattered electrons, X-rays, gas components and a current produced in the object.

When photomasks are being repaired, the defect to be repaired is identified and its shape is determined. This shape is scanned with the electron beam, and the desired chemical reaction is supported by the addition of suitable gases. The result of this chemical reaction is either that superfluous material is removed (is etched away), or that missing material is deposited, depending on which type of defect there is, and on which variant is therefore required for repairing the defect. One task in the case of these operations consists in detecting the correct end point of the chemical reaction, which is determined by virtue of the fact that sufficient material has been deposited or sufficient material has been removed, since the substrate is attacked if etching lasts too long and/or the material layer at the repaired site becomes too thick if too much material is deposited, and this would then become noticeable later in the lithography process as a defect of the mask.

In order to determine the correct end point of the chemical reaction, it is customary to detect interaction products, such as secondary electrons or backscattered electrons, emitted by the object during the process, and to evaluate the detected signals. The detection of backscattered electrons is fundamentally particularly suitable in the case of etching processes and of deposition processes, since the backscatter efficiency depends strongly on the atomic mass number of the scattering object, and the detected signal is therefore strongly dependent on the material. If the superfluous material, usually chromium or MoSi in the case of a photomask, has been completely removed, the electron beam is subsequently scattered at the substrate instead of on the chromium or MoSi, and this then leads to a change in signal.

Unfortunately, however, during processing most detector signals are so weak that they are already very noisy for statistical reasons, and so noise suppression is required.

Spatial frequency filtering for noise suppression is known from WO 1997001153 A. However, spatial frequency filtering cannot be applied in repairing defects, since defects usually do not have a specific spatial structure.

It is proposed in general in WO 2006050613-A to evaluate a "Region of Interest", which is generally a subset of the region to be repaired, in order to detect the processing end point.

US 20070278180 A1 discloses a multistep method for electron beam induced etching. Furthermore, a multistep method for a CVD method is disclosed in US 7220685 B2.

US 6608305 discloses a deposition method that uses different scanning speeds.

US6544692 B1 discloses further methods for charged particle induced imaging and etching.

A method according to the preamble of the present invention is known from the German laid open DE10261035.

It is the object of the present invention to specify a method for processing an object by means of a beam induced chemical reaction in which the end point detection for the processing step is improved.

The invention is defined by the appended independent claim 1.

In accordance with a first aspect of the present invention, this object is achieved by virtue of the fact that the object region to be processed is divided into a number of surface segments of similar areas. The signals of the reaction products, which are caused because of the interaction of the incident beam with the object within regions of the same surface segment, are integrated to form a total signal.

This first aspect of the present invention can be applied both when the interaction products are detected during the processing step, and when the detection of the interaction products is performed in a measuring step temporarily separate from the processing step.

In accordance with a second aspect of the invention, the detection of the interaction products for the end point determination is performed in a separate step in which one or more beam parameters of the incident beam have been varied in comparison with the beam parameters in the processing step.

It is, of course, also possible to apply both aspects of the invention concurrently.

A method according to the first aspect of the invention comprises the following steps:
- feeding a reaction gas onto a surface of the object;
- processing the object by directing an energetic beam onto a processing site in a region, which is to be processed, on the surface of the object, in order to deposit material on the object or to remove material from the object,
- detecting interaction products of the energetic beam with the object, and
- deciding whether the processing of the object must be continued or can be terminated with the aid of information which is obtained from the detected interaction products of the energetic beam with the object.

The energetic beam can be a light beam, for example a laser beam with ultrashort light pulses with pulse durations of 10 ps or less, or a beam of charged particles, in particular an electron beam.

When deciding whether the processing of the object must be continued or can be terminated, the region to be processed can be subdivided into a number of surface segments, and the interaction products detected upon the beam striking regions of the same surface segment can be integrated to form a total signal.

The areas of the surface segments can all have a similar area such that the noise component in all surface segments is to some extent the same. In a specific embodiment the areas of the surface segments can differ from one another by at most 300%.

In a specific embodiment it is possible that only signals are taken into account during formation of the total signal which are detected when the beam incident on the object has a distance from the edge of the region to be processed which is larger than a pre-defined minimum spacing. In a more specific embodiment the minimum spacing is selected such that the signal caused by the interaction products virtually exclusively exhibits material contrast.

In another specific embodiment each of the surface segments can have a minimum size such that, on the basis of the spatial integration over the surface segments and of a parallel temporal integration over a number of irradiation cycles, the statistical noise of the detected signal of the interaction products is smaller than the change in the detected signal of the interaction products which is to be expected on the basis of the change in material occurring during processing.

In another specific embodiment the surface segments can be determined such that the quotient of the square of the circumference around the surface segment and the area of the surface segment is smaller than 30 for at least 90% of the surface segments.

In another specific embodiment the processing of the object in step b) can be performed with a first set of beam parameters of the beam, and the scanning of the surface in step c) can be performed with a second set of beam parameters for the beam, and the second set of beam parameters deviates from the first set of beam parameters. In an even more specific embodiment the first set of beam parameters and the second set of beam parameters can differ from one another such that the processing rate is smaller for the second set of beam parameters than for the first set of beam parameters.

In another more specific embodiment the first and the second sets of beam parameters can differ from one another at least with regard to the pixel dwelltime of the beam at a location on the surface of the object, the pixel dwelltime being greater in the second set of beam parameters than in the first set of beam parameters.

In another more specific embodiment the first and second sets of beam parameters can differ from one another at least with regard to the sequence in which the beam strikes different locations on the surface of the object.

In another specific embodiment during scanning of the surface of the object in step c) the feed of the process gas to the object can be reduced when compared with the feed of process gas during processing of the object.

In another specific embodiment after the decision in process step d) the processing of the object by directing the beam onto the processing site on the surface of the object while reaction gas is being fed is continued in and only in those regions on the surface of the object in which no adequate processing has yet been established in the decision step d).

Depending on the type of mask to be processed and the type of defect to be repaired, the size of the surface segments can be empirically designed such that regions of the defect that have different material thicknesses belong to different surface segments. It is thereby possible, despite the surface integration, to take due account of typical thickness variation of the material to be removed, which in turn require different etching durations.

The signals that should be taken into account during formation of the total signal are those for which the beam incident on the object is at least at a minimum spacing away from the edge of the region to be processed. With other words, only signals should be taken into account during formation of the total signal which are detected when the beam incident on the object has a distance from the edge of the region to be processed which is larger than a pre-defined minimum spacing. It is possible thereby to ensure that the detected signal is not dominated by signal artifacts that occur, in particular, at the edge of a defect to be repaired. Such a signal artifact can be present, for example, whenever the detected signals are strongly influenced by the object topography. In particular, the minimum spacing can be selected such that the signal caused by the interaction products virtually exclusively exhibits material contrast.

The individual surface segments can be shaped such that the quotient of the square of the circumference of the surface segment and the area of the surface segment is smaller than 20 for at least 50% of all surface segments, and smaller than 30 for at least 90% of all surface segments. Ideally, the surface segments should have an approximately circular shape or square shape so that the spatial resolution of the evaluated signal is to some extent similar in the two mutually perpendicular spatial directions. However, this is not possible as a rule, since with circular surface segments (shapes) surface filling without overlapping is impossible, and the edge of the defect to be repaired or of the region to be processed does not generally exhibit an ideally round or straight shape. When the above quotient is smaller than 20 for at least 50% of all surface segments and is smaller than 30 for at least 90% of all surface segments, the deviation from the circular shape or square shape is still acceptably slight, and so there are still no resulting remarkable or disturbing direction-dependent differences in the resolution.

All surface segments taken together should precisely cover the area of the entire region to be processed. There should not be any points remaining in the region to be processed that are not assigned to a surface segment. On the other hand, the surface segments should also not be mutually overlapping (such that a point of the region to be processed is assigned to more than one surface segment), since otherwise another surface segment would also be varied upon masking of a surface segment.

A method in accordance with the second aspect of the invention comprises the following method steps:
- feeding a reaction gas onto a surface of the object;
- processing the object by directing an energetic beam onto a processing site in a region to be processed on the surface of the object, in order to deposit material on the object or to remove material from the object,
- scanning the surface of the object with the energetic beam and detecting interaction products of the energetic beam with the object, and
- deciding whether the processing of the object must be continued or can be terminated with the aid of information which is obtained from the detected interaction products of the energetic beam with the object.

The energetic beam can be a light beam, for example a laser beam with ultrashort light pulses with pulse durations of 10 ps or less, or a beam of charged particles, in particular an electron beam.

The processing of the object in the second step can be performed with a first set of beam parameters for the beam, and the scanning of the surface in the third step can be performed with a second set of beam parameters for the beam, and the second set of beam parameters can deviate from the first set of beam parameters.

The first set of beam parameters can in this case be optimized to the processing procedure, while the second set of beam parameters can be optimized for the detection of the interaction products. In particular, the first set of beam parameters and the second set of beam parameters can differ from one another such that the processing rate is smaller for the second set of beam parameters than for the first set of beam parameters.

The first and the second sets of beam parameters can differ from one another with regard to the pixel dwelltime of the beam at a location on the surface of the object, the pixel dwelltime being greater in the second set of beam parameters than in the first set of beam parameters. Owing to the lengthened pixel dwelltime of the beam at a location, after a short time a depletion of the process gas occurs at this location, the result being that the chemical process is stopped, or at least slows down, despite the incident beam of charged particles.

The first and second sets of beam parameters can differ from one another with regard to the sequence in which the beam strikes different locations on the surface of the sample. Particularly in the case of a meandering scanning strategy both in the processing step and in the detection of the end point signal, the spacings of the meanders can be selected to be smaller in the detection of the end point signal than in the processing step. A reduction or slowing down of the chemical process is likewise achieved thereby.

During scanning of the surface of the object in the third step, the feeding of the process gas to the object can be reduced, or even stopped, when compared with the feeding of process gas during processing of the object. A reduction or slowing down of the chemical process is likewise achieved thereby.

The above-named measures for reducing or slowing down the chemical process can be applied individually or in combination with one another.

After the decision in the fourth processing step, the processing of the object by directing a beam onto the processing site on the surface of the object while reaction gas is being fed can be continued in and only in those regions on the surface of the object in which no adequate processing has yet been established in the decision step. It is thereby possible to take account of spatially different processing thicknesses or processing speeds such that the processing is continued at each location precisely as long as required on the basis of the local properties.

Details of the invention are explained in more detail below with the aid of the figures, in which:
- figure 1: shows a schematic sketch of a processing apparatus for processing an object,
- figures 2a to 2d: show plan views of a structure with a defect,
- figure 3: shows a flowchart of a method in which the region to be repaired is broken down into surface segments, and
- figure 4: shows a flowchart for segmenting the region to be repaired.

Identical reference symbols denote identical components.

The processing system 100 comprises an electron microscope 1, a gas feed arrangement 8 for feeding reaction gas to a site, to be processed, of an object O held on an object holder 81, and an electrode arrangement 9.

In a direction of the electron beam propagation, the electron microscope 1 comprises an electron beam source 3, first focusing/deflecting elements 48, a backscattered electron detector 6, an energy selector 7, a secondary electron detector 5 and a focusing lens 4. Second focusing/deflecting elements 47 are arranged inside the focusing lens. The focusing lens 4 is a combination composed of a magnetic lens and an electrostatic immersion lens. The magnetic lens comprises an inner pole piece 42, an outer pole piece 41 and a coil 43 arranged there between, a lower end of the inner pole piece 42 and a lower end of the outer pole piece 41 forming a substantially axial gap 44 in which, during induction of a magnetic flux through the pole pieces 41, 42 by a current flow in the coil 43, a magnetic field is generated that emerges substantially in the region of the axial gap 44. This magnetic field leads to a focusing of the electron beam, which is accelerated toward the object O from the electron beam source 3. The electrostatic immersion lens comprises a radiation tube 45 that extends through an inner space of the magnetic lens 4 formed by the inner pole piece 42 and the outer pole piece 41. The electrostatic immersion lens furthermore comprises a terminal electrode 46 arranged at a spacing from a lower end of the radiation tube 45. By applying a suitable electric field between the radiation tube 45 and the terminal electrode 46 with the aid of a voltage source (indicated schematically, without reference symbol), it is possible to decelerate the primary electrons to a primary energy of approximately 1 keV suitable for inspecting photomasks. In the embodiment illustrated, the radiation tube can, for example, be at +8 keV while the terminal electrode 46 is grounded.

The electron microscope 1 is subdivided into four different vacuum spaces 21, 22, 23, 24 that are partially separated from one another by pressure stages 25, 26, 27. A first vacuum space 21 contains the electron beam source 3. The first vacuum space 21 is connected by a first connection 29 to an ion getter pump 37. During operation of the electron microscope, a pressure in the range from approximately 10⁻⁹ to 10⁻¹⁰ mbar, for example, prevails in the first vacuum space 21. A first pressure stage 25 is formed by an opening 25 symmetrically surrounding the electron beam path. A second vacuum space 22 is connected via a second connection 30 to a second vacuum pump 38, an ion getter pump. A second pressure stage separates the second vacuum space 22 partially from a third vacuum space 23. During operation of the electron microscope, the pressure in the second vacuum space 22 can be in the region of approximately 10⁻⁷ mbar, for example. The backscattered electron detector 6 and the energy selector 7 are arranged in the third vacuum space 23. The third vacuum space 23 is partially separated from the second and from a fourth vacuum space 22, 24 by pressure stages 26 and 27, respectively, and has a connection 31 that connects the third vacuum space to a third vacuum pump 29. During operation, the pressure in the third vacuum space can be in the region of approximately 10⁻⁵ mbar. The fourth vacuum space 24 is partially separated from the third vacuum space 23 by the third pressure stage 27. In the exemplary embodiment illustrated, the third pressure stage 27 comprises the secondary electron detector 5. In this case, an opening of the third pressure stage 27 is formed by the opening, penetrated by the electron beam, of the secondary electron detector 5. The secondary electron detector 5 is held in this case in the interior of the electron microscope 1 such that a pressure compensation between the partially separated vacuum spaces 23, 24 can be performed only through the opening in the secondary electron detector. The fourth vacuum space 24 further has a gas conducting connection 28 to the interior of the vacuum chamber 2. The gas conducting connection 28 is provided here by a simple metal tube. The reactive gas fed by the gas feed is discharged from the fourth vacuum space 24 to the vacuum chamber 2 through the metal tube which has a relatively large diameter in order to afford as little resistance as possible to the transport of gas into the interior of the vacuum chamber 2. In the exemplary embodiment illustrated, the radiation tube 45 has a lower cylinder-shaped part in the beam direction a region that expands conically in the direction of the secondary electron detector 5 and then extends upward, in the shape of a cylinder of comparatively large diameter, as far as through the second vacuum space 22. The radiation tube 45 thus surrounds both the secondary electron detector 5 and energy selector 7, as well as the backscattered electron detector 6. The radiation tube 45 is held at a spacing below the secondary electron detector 5 by a vacuum-tight holder, for example made from ceramic, and is connected to the lower pole piece 41 in a vacuum-tight fashion in such a way that the fourth vacuum space 24 substantially comprises an inner space of the radiation tube and an intermediate space between the insulation and the third vacuum space 23 adjoining in the direction of the electron beam source 3. In the region, that is to say in the vicinity, of the third pressure stage 27 a pressure in the region of approximately a few 10⁻⁴ mbar, for example, prevails during operation in the interior of the fourth vacuum space 24, whereas a vacuum is achieved in the region of approximately a few 10⁻⁵ mbar, for example, in the interior of the vacuum chamber 2. The vacuum chamber 2 has a connection 32 that connects the interior of the vacuum chamber 2 to a fourth vacuum pump 40. The first, the second, the third and the combination of fourth vacuum space and vacuum chamber can thus each be evacuated individually, thus enabling an efficient operation of the electron microscope even when gas is fed into the vacuum chamber.

A detection surface 51 of the secondary electron detector is therefore arranged in the fourth vacuum space 24, while the backscattered electron detector 6 is arranged in the third vacuum space 23, in which a better vacuum is achieved. The energy selector 7 is arranged in front of the backscattered electron detector 6 in such a way that all electrons emitted by the object O or backscattered thereon must pass the energy selector 7 in order to be able to reach a detection surface of the backscattered electron detector 6. In the embodiment illustrated, the energy selector 7 comprises a first grid 71, a second grid 72 and a voltage source 73 for producing a suitable electric field between the first and the second grids, in order to enable the reflection of secondary electrons emerging from the object surface. The grids are arranged parallel to one another and enclose in an annular fashion the electron beam path of the primary electron beam produced by the electron beam source 3. In the exemplary embodiment illustrated, the first grid 71 is connected to the voltage source 73, while the second grid 72 is coupled to the radiation tube 45 and thus is at the same potential as the latter. It is possible to introduce an insulating tube into the opening, formed by the grids 71, 72 and penetrated by the electron beam, in order to protect the primary electron beam against the influence of the electric field applied between the two grids 71, 72. The electric field applied by means of the voltage source 73 is adapted to the primary electron energy and the particularities of the inspected and processed sample in such a way that the backscattered electrons pass through the electric field and are detected at the backscattered electron detector, while the secondary electrons are reflected due to their lower kinetic energy and are therefore not detected. The strength of the electric field, and thus the level of the detection signal, can be improved by setting the potential difference applied to the grids.

The embodiment illustrated further comprises an electrode arrangement 9 that comprises a shielding electrode 91 that is arranged annularly around the electron beam path and has a central opening 92 that enables an undisturbed passage of the primary electron beam and a largely unimpeded passage of secondary and backscattered electrons. A suitable voltage source (illustrated schematically without reference symbol) can be used to apply a suitable voltage to the electrode 91 in order to shield the primary electron beam effectively from an electric field produced by charging the object O.

A fast deflection element 49 is arranged between the terminal electrode 46 and the electrode arrangement 9. The deflection element, which is formed as an electrostatic multipole element, can be used to deflect the electron beam in the plane of the object in order to move the electron beam with the desired scanning strategy over the sample region to be processed or to be analyzed.

In a method for automatic end point selection, an object is inspected in a first step, said object being in the case of a mask repair a photomask in which, for example, miniaturized molybdenum structures are applied to a quartz substrate. During the inspection, defects in the mask are identified and processing steps are selected in order to eliminate or repair the defect. A site to be processed on the object O is then brought in a processing step into the region of the primary electron beam, and the gas feeding arrangement 8 is used to feed a reaction gas that is excited by the electrons of the electron beam and thus becomes chemically reactive. Material can thereby be removed, for example. After a certain time interval of the material removal, the processed site is inspected once again. The inspection is performed in this case by detecting backscattered electrons from which secondary electrons are separated by means of the energy selector 7. Secondary electrons emerging from the surface of the object O enter the interior of the electron microscope 1 and strike the detection surface 51 of the secondary electron detector 5 in the fourth vacuum space. Those secondary electrons that penetrate into the third vacuum chamber through the opening of the secondary electron detector are reflected by applying a suitable voltage between the first grid 71 and the second grid 72 of the energy selector 7. Only the more highly energetic backscattered electrons pass the energy selector 7 and reach the backscattered electron detector 6. The electron image on the basis of which a decision is taken regarding the reaching of an end point is produced on the basis of the detected backscattered electrons. The processing of the object can be stopped if the electron image produced corresponds to a desired image. Otherwise, another processing step is performed, accompanied by the feeding of reaction gas. In a particularly advantageous way, this mode of procedure enables an automatic end point selection, particularly in the repair of photomasks.

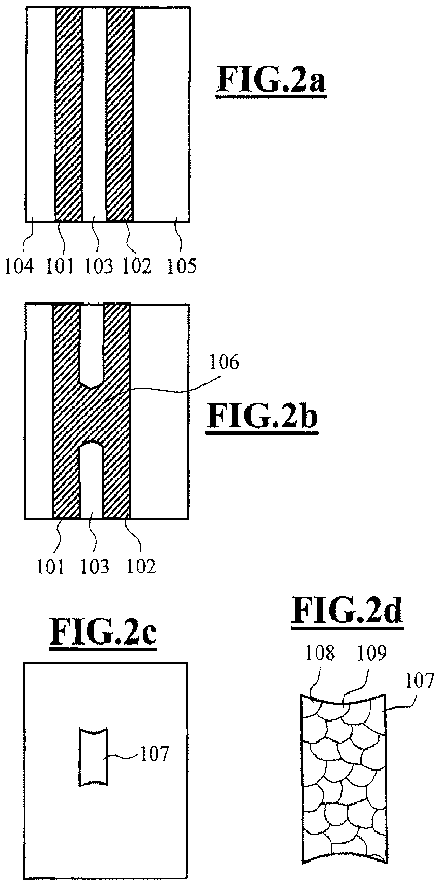

Figure 2a is a schematic of an SEM image of a mask structure for producing two parallel conductor tracks. To this end, the mask structure has two strips 101, 102 that absorb light of the wafer scanners later used and between which a transparent strip 103 is located, and which are embedded laterally in a transparent environment. In an SEM image produced by detecting backscattered electrons, the absorbing strips 101, 102 appear to be brighter because they consist of chromium or MoSi, and these materials have a larger backscattering coefficient than the environment 104, 103, 105 in which the electrons are scattered on the quartz substrate.

Figure 2b illustrates the same region of the mask when the mask structure has a so-called opaque defect. In a region 106, the two opaque strips 101, 102 are undesirably connected to one another. Where this mask structure to be used in a wafer scanner, an undesired electrical short circuit would result in the region 106. Consequently, in a repair process the excessive material in this region 106 is to be removed.

Figure 2c illustrates the region to be repaired as extracted from the mask image by image analysis. In a subsequent step, the region 107 to be repaired, which is illustrated in an enlarged fashion in figure 2d, is broken down into a multiplicity of surface segments 108, 109 that all have an area of approximately equal size, and which, when assembled, produce the region to be repaired. Breaking down the region to be repaired into surface segments 108, 109 promotes the end point detection, that is to say it serves to determine the instant at which the processing of the mask is stopped in the individual surface segments. To this end, the intensity of the backscattered electrons is detected either when repairing the mask, or in a separate measurement step with the aid of the backscattered electron detector. In order to reduce the signal noise that cannot be avoided because of the Poisson statistics of the detected backscattered electrons, the signals that belong to a single surface segment 108, 109 are respectively integrated. A single measured value results for each surface segment as a consequence thereof. If this measured value undershoots or overshoots a prescribed desired value, the processing is then stopped at this surface segment. Consequently, the scanning strategy with which the electron beam is guided over the object is changed for the further processing such that subsequently the processing is continued only in the surface segments in which the signal, integrated over the surface segment, of the backscattered electrons has not yet reached the prescribed limiting value.

The following points of view are taken into account when defining the individual surface segments. All surface segments must have a minimum size so that the averaging over each of the surface segments has the required signal-to-noise ratio. On the other hand, each of the surface segments also has a maximum size so that typical variations in the defect, such as different defect heights, inhomogeneities in the etching or deposition rate, are determined with sufficient spatial resolution during the end point detection. In order to optimize the signal-to-noise ratio, the areas of all the surface segments should be approximately of the same size. In this process, it is respectively only such pixels or object points that are at a specific minimum spacing from the edge of the region 107 to be repaired which are counted to the size of the surface segments. The reason for this is that the backscattered electron signal is frequently corrupted at the edge of the region to be repaired by effects that are determined by the surface topography of the object and/or of the mask. Furthermore, all surface segments should exhibit an approximately round or square shape such that the spatial resolution in the mutually perpendicular spatial directions remains to some extent homogeneous despite the spatial filtering that necessarily results from averaging over all points of the same surface segment. To this end, the quotient of the square of the circumference around the surface segment and the area of the surface segment should be smaller than 30, preferably smaller than 23, for each surface segment.

Since the concrete parameters depend both on the respective mask type and on the respective defect type, the parameters for the individual surface segments are determined empirically in corresponding test runs, and then input into the control software. To this end, defective masks can be etched or repaired in test passes. Pixel for pixel, the signal characteristic of the end point signal is then determined as a function of the processing cycles (loops). It is then determined from the signal characteristic to what distance from the edge of the defect the end point signal is still influenced by the edge of the defect, and which minimum spacing from the edge of the defect is therefore to be observed for a good end point signal. Upon later use of the apparatus, the appropriate values are then selected by the system after selection of the mask type and the defect type, and the division into the surface segments is then undertaken by means of a software program.

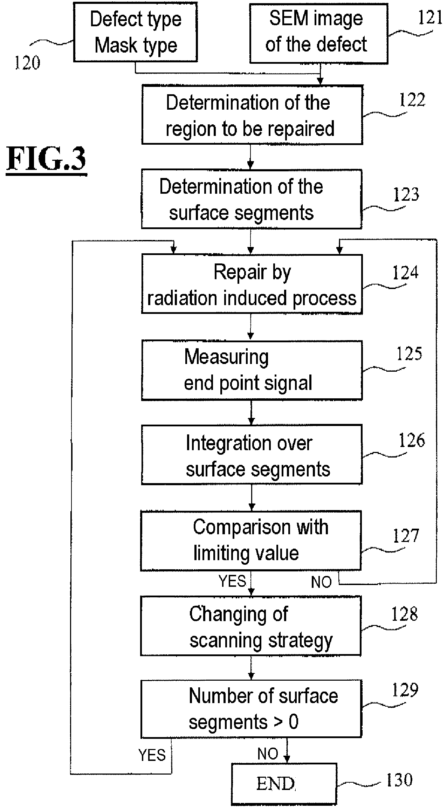

The process itself is reproduced schematically in figure 3. In a first step 121, a scanning electron microscope image of the defect - or, more accurately, the mask with the defect to be repaired - is shown. By taking account of the defect type and the mask type, which were either previously determined or input by the user in a step 120, the region to be repaired is then firstly determined by image analysis in a step 122, and the suitable breakdown of the region to be repaired into surface segments of approximately the same size is subsequently undertaken in a step 123. The region to be repaired then simultaneously also defines in spatial terms the scanning strategy with which the electron beam is later guided over the object. Thereafter, the repair of the defect by a radiation induced chemical process then begins in a step 124. To this end, to the object is fed a suitable gas or gas mixture via a gas inlet system, and the electron beam is guided over the individual points of the region to be repaired. The dwelltime for which the electron beam remains at each location, and at a time at which the electron beam again irradiates on the next occasion a region already irradiated earlier (the so-called refresh time) are determined by the required gas chemical process, and are likewise part of the scanning strategy.

The end point signal is detected in a step 125, either during the repair process or in a separate measurement step in which, by suitable measures such as a change in the dwelltime, in the refresh time and/or a reduction in the gas flow, the chemical processing procedure is slowed down when compared with the situation in the processing step 124, or is stopped. In the particular case described, the electrons backscattered on the object are detected for the end point signal. The end point signal is then integrated over each surface segment in a step 126, that is to say the step 126 supplies precisely one measured value for each surface segment. In a subsequent step 127, the measured value obtained in step 126 for each surface segment is compared with a previously defined limiting value. If the limiting value is not reached for any of the surface segments, the system returns to the step 124 and continues the repair of the defect in all surface segments. However, if the limiting value is reached in one or more surface segments, the scanning strategy is changed in a subsequent step 128. This change in the scanning strategy amounts to the spatial coordinates of all object points in those surface segments where the limiting value is reached being removed from the scanning strategy, that is to say the points or pixels belonging to these surface segments are later no longer approached by the electron beam.

In a subsequent step 129, it is further checked whether at least one surface segment that requires further processing is still present after changing the scanning strategy. If this is the case, the system returns to the processing step 124 with a changed scanning strategy. Otherwise, the end 130 of the process is reached when the limiting value has been reached in all surface segments.

If the end point signal is obtained in a separate measurement step in the method previously described with the aid of figure 3, it should be ensured that no, or only a reduced, radiation induced chemistry takes place in the measurement step. This can be achieved in general by virtue of the fact that a depletion of the process gas occurs in the measurement step. One possibility to this end is, of course, to reduce the gas flow during the measurement step, or to stop it entirely. However, since the speed at which the gas flow can be changed is relatively low, it is more sensible to change the scanning strategy in the measurement step when compared with the scanning strategy in the processing step. To this end, the time for which the electron beam dwells at the same location, that is to say the so-called pixel dwelltime, can be lengthened in the measurement step, and/or the duration which lies at least between the approach to the same location on the object, that is to say the refresh time, can be shortened. The effect of both measures is that the locally available process gas is depleted at the respective location after a relatively short time, and consequently the gas chemical process is slowed down and more or less comes to a standstill. It is possible in this way to exclude overetching or overdeposition during the measurement step.

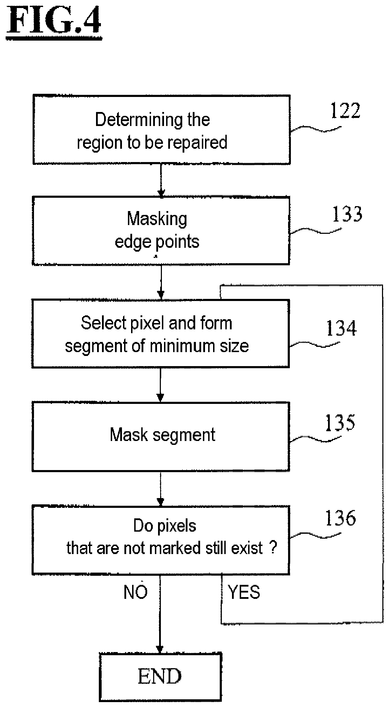

Figure 4 illustrates an algorithm for subdividing the region to be processed into surface segments. It starts after, in step 122 in figure 3, the region to be processed is determined in terms of position and shape. It also presupposes that a minimum number of pixels that each surface segment must have is prescribed. In a following step 133, all edge points are then firstly masked, that is to say all points and/or pixels that do not exhibit an empirically determined minimum spacing from the edge of the region to be repaired. In a further step 134, an unmasked pixel is then selected and combined with pixels in the environment to form a surface segment. In this process, pixels are added until the surface segment formed has the required minimum size, that is to say the required minimum number of pixels. In this process, it can either be attempted, starting from a circle around the pixel, to further expand the circle, or a start is made from a substantially square surface that is then expanded.

If a segment has reached the required size, the pixels belonging to this segment are masked in a following step 135, and a check is made in a step 136 as to whether there are still present further unmasked pixels that have not yet been assigned to a surface segment. If this is the case, the system returns to step 134 and selects a new unmasked pixel in order to form a new surface segment.

In general, it can come about that individual unmasked pixels that are not yet assigned to a surface segment are still left over at the end of the algorithm. These are then added to a already existing neighboring surface segment.

Experiments have shown that on the basis of a target number of 400 pixels per surface segment and of a square basic surface as desired shape, the above described algorithm leads to a division of the region to be repaired in the case of which it holds for 50% of the surface segments that the quotient of the square of the circumference around the surface segment and of the area of the surface segment is smaller than 18, and that it holds for 90% of the surface segments that the quotient of the square of the circumference around the surface segment and of the area of the surface segment is smaller than 23. The size distribution of the surface segments is virtually constant in this case, that is to say apart from a few exceptions virtually all surface segments have the prescribed size, and there are only a few surface segments at the edge of the region to be processed that are larger.

If the same algorithm is carried out in the form in which circular surfaces form the basic shape, said circular surfaces then being expanded by adding pixels, it is seen that it then holds for 50% of the surface segments that the quotient of the square of the circumference around the surface segment and of the area of the surface segment is smaller than 15, and that it holds for 90% of the surface segments that the quotient of the square of the circumference around the surface segment and of the the area of the surface segment is smaller than 18. However, a relatively large number of surface segments result which are larger than the required pixel number. This algorithm therefore yields advantages to the effect that the spatial measurement resolution is relatively homogenous in mutually perpendicular directions, but at the expense of a larger number of larger surface segments, and thus at the expense of a lower spatial resolution overall, or a larger inhomogeneity of the spatial resolution of the end point detection. The other algorithm, by contrast, yields relatively uniformly large surface segments, although with the disadvantage that deviations from the ideal circular or square shapes are more pronounced so that the spatial measurement resolution is somewhat inhomogeneous in mutually perpendicular directions. Further experiments have shown that both algorithms lead to a complete and an unambiguous division of the region to be processed into surface segments of which the largest surface segment, for the requirement that each comprise at least 400 pixel, has less than 800 pixels, the largest surface segment resulting thus having an area at most twice as large as the smallest surface segment.

The effect that is achieved by evaluating the surface segments during the end point detection can be shown in the simplest way with the aid of the following numerical examples: dwelltimes typically used in the electron beam induced chemical processes lie in the range between 30 and 200 ms, and typical currents lie in the range from 10 to 100 pA. Typical refresh times, that is to say times which at least must pass until the same pixel is again irradiated with the electron beam, lie between 50 µs and 10 ns. Given a current of 50 pA and an irradiation duration of 100 ns, it is possible to calculate that approximately 30 primary electrons are incident on each pixel per pixel and per cycle (loop). If the signal is integrated over 100 cycles, the result is 3000 primary electrons incident in the 100 cycles per pixel.

Typical backscattering coefficients, that is to say the number of the electrons backscattered per incident primary electron, depend on the material and are approximately 0.29 for chromium, approximately 0.21 for MoSi, and approximately 0.15 for quartz. It follows therefrom that for chromium on quartz, the backscattered electron signal drops by approximately 50% when the chromium is completely removed at a site. In the case of MoSi on quartz, the difference is substantially less: with this material combination a difference of only approximately 20% occurs in the backscattered electron signal.

However, not every backscattered electron is detected, since the electrons are, at all, scattered into the entire half space, and only a portion thereof are incident on the detector. Typical detector efficiencies for backscattered electrons are approximately 5 ^{∗} 10⁻⁴.

Multiplying the above named efficiencies by the named number of electrons per 100 cycles results in 0.3 detected electrons to be expected per 100 cycles. As a result of the Poisson distribution, a statistical spread of the results of approximately +- 0.55 is to be expected, that is to say the signal noise is approximately double the size of the signal to be expected when the electrons are scattered on chromium and/or MoSi. As a consequence thereof, the expected change in the signal of 20% and 50%, respectively, referred to the total signal cannot be detected as a result of the statistical noise.

However, there is a considerable change in the situation if integration is performed over surface segments that comprise 100 to 1000 pixel: for integration over 400 pixels, instead of the 0.3 electrons to be expected the result is approximately 120 electrons per surface segment and 100 cycles. The statistical spread to be expected on the basis of Poisson statistics is then 11 events, that is to say the noise is only approximately 10% of the signal value. In these circumstances, the difference in signal to be expected of 50% for chromium on quartz or 20% for MoSi on quartz can be detected, since this signal difference is now at least as large as the noise, or the noise is smaller than the difference in signal to be expected. An alternative to the spatial integration by combining pixels to form surface segments would be an appropriate lengthening of the temporal integration. However, there would then be a need to integrate over 100^{∗}400 = 40 000 cycles instead over 100 cycles in order to reach the same signal-to-noise ratio, and this is permissible only if no gas chemistry is proceeding during the signal acquisition for the end point detection, since such a large number of cycles in conjunction with activated gas chemistry can certainly correspond to etching depths or deposition thicknesses of several 100 nm.

As may be seen, the inventive method provides the freedom of setting the signal-to-noise ratio of the detected interaction products via two parameters, specifically via the number of the cycles over which the signal is acquired, and via the size of the surface segments over which the signal is spatially integrated. It is sensible to set these parameters such that the statistical noise of the detected interaction products is lower than the difference in signal, to be expected upon processing, for the detected interaction products on the basis of the material that is changing during processing and on which the interaction products are produced. The number of the cycles over which the signal is temporarily integrated is selected, once again, such that the attainment of the processing product is checked sufficiently frequently without too great an enlargement of the entire processing period. The selection of the appropriate parameters is, of course, dependent on the respective individual case. It has proved to be expedient to perform temporal integration over 50 to 1000 cycles. The result, given customary processing rates in the range from 1000 to 100 000 cycles per 100 nm processing thickness, is that checking of the end point is carried out statistically after at most every 2 nm processing thickness, preferably after each 1 nm processing depth, without unduly lengthening the total processing period. It is to be understood here, that the shorter temporal integration period of 50 cycles is applied in the case of processes with a high processing speed, that is to say for those in which processing rates of approximately 1000 cycles per removal of 100 nm occur, and longer temporal integration periods of approximately 1000 cycles are applied for processes of lower processing speed in which approximately 100 000 cycles per 100 nm processing thickness are required.

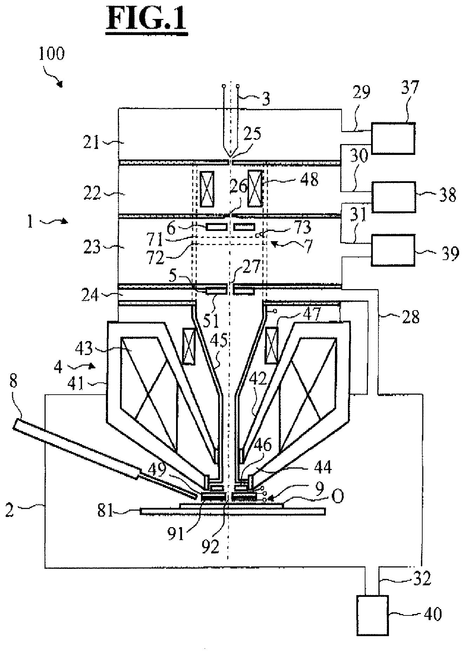

The invention has been described above using the example in which the gas chemical process is induced by an electron beam. However, the invention can likewise be applied when the gas chemical process is initiated by an ion beam or by ultrashort light pulses. If the radiation induced gas chemical process is to be initiated by an ion beam, there would be a need either to replace the electron optical system illustrated in figure 1 by an ion optical system, or to provide an ion optical system - that is to say a so-called crossbeam system or dual beam system - in addition to the electron optical system. Ion optical systems differ from electron optical systems in that an ion source is used instead of the electron source, and the lenses used are exclusively electrostatic lenses. Moreover, as a result of the changed polarity of the particles in ion optical systems, the electrostatic potentials respectively applied generally have an inverse sign than is the case in electron optical systems.

If the radiation induced gas chemical process is to be induced by a high energy laser beam, the electron optical system illustrated in figure 1 would have to be replaced by a setup corresponding to a laser scanning microscope, or the optics corresponding to a laser scanning microscope would have to be provided in addition. Such a laser scanning microscope should then have as a light source a high energy laser that emits temporally ultrashort light pulses, that is to say light pulses with pulse durations below 10 ps.

Also, the processing has been illustrated above chiefly by the example of etching, that is to say the repair of so-called opaque defects. The same inverse principles also apply, however, when material is deposited for the repair. In this case, whenever the surface segment is completely repaired, a rise in signal occurs by comparison with the signal of the interaction products before the repair, the rise in signal resulting, just as in the case described above, from the different backscattering coefficients of the various materials, and analogous conditions resulting with regard to the signal-to-noise ratio.

Finally, the invention has been explained referring to the example of mask repair. However, it can equally well be used when radiation induced chemical processes are being used for other purposes, for example in the case of so-called via etching and in the production of the conductor tracks in semiconductor components in order to modify the latter for examinations and tests.

The invention has been explained in the context of a comprehensive system. However the invention does not only comprise the combination of all features of the comprehensive system but also comprises all individual features which are disclosed as well as all subcombinations of all disclosed features.

## Claims

1. A method for processing an object (O) with miniaturized structures, having the steps of:
a) feeding the reaction gas onto a surface of the object (O);
b) processing the object (O) by directing an energetic beam onto a processing site on the surface of the object (O), in order to deposit material on the object or to remove material from the object (O),
c) scanning the surface of the object (O) with the energetic beam and detecting interaction products of the energetic beam with the object (O), and
d) deciding whether the processing of the object (O) must be continued or can be terminated with the aid of information which is obtained from the detected interaction products of the energetic beam with the object (O),
e) in which the processing of the object (O) in step b) is performed with a first set of beam parameters of the beam, and the scanning of the surface in step c) is performed with a second set of beam parameters of the energetic beam, and the second set of beam parameters deviates from the first set of the energetic beam parameters
**characterized in that**
the first and the second sets of beam parameters differ from one another at least with regard to the pixel dwelltime of the beam at a location on the surface of the object (O), the pixel dwelltime being smaller in the processing step b) than in step c).

2. The method as claimed in claim 1, in which the first and the second sets of beam parameters differ from one another such that during processing of the object (O) in step b) the processing rate is greater than in step c).

3. The method as claimed in one of claims 1 to 2, in which the first and second sets of beam parameters differ from one another at least with regard to the sequence in which the beam strikes different locations on the surface of the object (O).

4. The method as claimed in one of claims 1 to 3, in which during scanning of the surface of the object (O) in step c) the feeding of the process gas to the object (O) is reduced or stopped.

5. The method as claimed in one of claims 1 to 4, in which after the decision in process step d) the processing of the object (O) by directing a beam onto a processing site on the surface of the object (O) while reaction gas is being fed is continued in and only in those regions on the surface of the object (O) in which no adequate processing has yet been established in the decision step d).

6. The method as claimed in one of claims 1 to 5, in which an object region to be processed (107) is subdivided into a number of surface segments (108,109), and the interaction products detected upon the beam striking regions of the same surface segment is integrated to form a total signal in order to determine whether processing of the object (O) must be continued or can be terminated.

7. The method as claimed in claim 6, in which the areas of the surface segments (108,109) differ from one another by at most 300%.

8. The method as claimed in claim 6 or 7, in which only signals are taken into account during formation of the total signal which are detected when the beam incident on the object (O) has a distance from the edge of the region to be processed (107) which is larger than a pre-defined minimum spacing.

9. The method as claimed in claim 8, in which the minimum spacing is selected such that the signal caused by the interaction products virtually exclusively exhibits material contrast.

10. The method as claimed in one of claims 6 - 9, in which each of the surface segments (108,109) has a minimum size such that, on the basis of the spatial integration over the surface segments (126) and of a parallel temporal integration over a number of irradiation cycles, the statistical noise of the detected signal of the interaction products is smaller than the change in the detected signal of the interaction products which is to be expected on the basis of the change in material occurring during processing.

11. The method as claimed in one of claims 6 to 10, in which the surface segments (108,109) are determined such that the quotient of the square of the circumference of the surface segment and the area of the surface segment is smaller than 30 for at least 90% of the surface segments.

12. The method as claimed in one of claims 1 to 11, in which the energetic beam is a beam of charged particles.

13. The method as claimed in claim 12, in which the beam of charged particles is an electron beam.

## Patentansprüche

1. Verfahren zum Bearbeiten eines Objekts (O) mit miniaturisierten Strukturen, mit den folgenden Schritten:
a) Zuführen des Reaktionsgases auf eine Oberfläche des Objekts (O);
b) Bearbeiten des Objekts (O) durch Richten eines energetischen Strahls auf eine Bearbeitungsstelle auf der Oberfläche des Objekts (O), um Material auf dem Objekt abzuscheiden oder um Material von dem Objekt (O) zu entfernen,
c) Abtasten der Oberfläche des Objekts (O) mit dem energetischen Strahl und Detektieren von Wechselwirkungsprodukten des energetischen Strahls mit dem Objekt (O), und
d) Entscheiden, ob die Bearbeitung des Objekts (O) fortgesetzt werden muss oder beendet werden kann, mit Hilfe von Informationen, die von den detektierten Wechselwirkungsprodukten des energetischen Strahls mit dem Objekt (O) erhalten werden,
e) wobei die Bearbeitung des Objekts (O) in Schritt b) mit einer ersten Menge von Strahlparametern des Strahls durchgeführt wird und das Abtasten der Oberfläche in Schritt c) mit einer zweiten Menge von Strahlparametern des energetischen Strahls durchgeführt wird und die zweite Menge von Strahlparametern von der ersten Menge der Parameter des energetischen Strahls abweicht, **dadurch gekennzeichnet, dass** die erste und die zweite Menge von Strahlparametern voneinander mindestens bezüglich der Pixel-Verweilzeit des Strahls an einem Ort auf der Oberfläche des Objekts (O) abweichen, wobei die Pixel-Verweilzeit in dem Verarbeitungsschritt b) kleiner ist als in Schritt c).

2. Verfahren nach Anspruch 1, bei dem die erste und die zweite Menge von Strahlparametern derart voneinander abweichen, dass während der Bearbeitung des Objekts (O) in Schritt b) die Bearbeitungsrate größer ist als in Schritt c) .

3. Verfahren nach einem der Ansprüche 1 bis 2, bei dem die erste und zweite Menge von Strahlparametern zumindest bezüglich der Reihenfolge, in der der Strahl auf verschiedene Orte auf der Oberfläche des Objekts (O) trifft, voneinander abweichen.

4. Verfahren nach einem der Ansprüche 1 bis 3, bei dem während des Abtastens der Oberfläche des Objekts (O) in Schritt c) das Zuführen des Prozessgases zu dem Objekt (O) reduziert oder gestoppt wird.

5. Verfahren nach einem der Ansprüche 1 bis 4, bei dem nach der Entscheidung in Prozessschritt d) die Bearbeitung des Objekts (O) durch Richten eines Strahls auf eine Bearbeitungsstelle auf der Oberfläche des Objekts (O), während Reaktionsgas zugeführt wird, in und nur in jenen Bereichen auf der Oberfläche des Objekts (O) fortgesetzt wird, bei denen in dem Entscheidungsschritt d) noch keine ausreichende Bearbeitung etabliert worden ist.

6. Verfahren nach einem der Ansprüche 1 bis 5, bei dem ein zu Bearbeitendes Objektgebiet (107) in eine Anzahl von Oberflächensegmenten (108, 109) unterteilt wird und die auf den Strahlauftreffgebieten des gleichen Oberflächensegments detektierten Wechselwirkungsprodukte integriert werden, um ein Gesamtsignal auszubilden, um zu bestimmen, ob eine Bearbeitung des Objekts (O) fortgesetzt werden muss oder gestoppt werden kann.

7. Verfahren nach Anspruch 6, bei dem die Bereiche der Oberflächensegmente (108, 109) um höchstens 300% voneinander abweichen.

8. Verfahren nach Anspruch 6 oder 7, bei dem nur Signale während der Bildung des Gesamtsignals berücksichtigt werden, die detektiert werden, wenn der auf das Objekt (O) einfallende Strahl eine Distanz von dem Rand des zu Bearbeitenden Gebiets (107) besitzt, die größer ist als eine vordefinierte kleinste Beabstandung.

9. Verfahren nach Anspruch 8, bei dem die kleinste Beabstandung derart gewählt wird, dass das durch die Wechselwirkungsprodukte verursachte Signal so gut wie ausschließlich einen Materialkontrast aufweist.

10. Verfahren nach einem der Ansprüche 6-9, bei dem jedes der Oberflächensegmente (108, 109) eine kleinste Größe derart besitzt, dass auf der Basis der räumlichen Integration über den Oberflächensegmenten (126) und einer parallelen zeitlichen Integration über eine Anzahl von Bestrahlungszyklen das statistische Rauschen des detektierten Signals der Wechselwirkungsprodukte kleiner ist als die Änderung bei dem detektierten Signal der Wechselwirkungsprodukte, das auf Basis der Materialänderung, die während der Bearbeitung auftritt, zu erwarten ist.

11. Verfahren nach einem der Ansprüche 6 bis 10, bei dem die Oberflächensegmente (108, 109) derart bestimmt werden, dass der Quotient aus dem Quadrat des Umfangs des Oberflächensegments und der Fläche des Oberflächensegments kleiner ist als 30 für mindestens 90% der Oberflächensegmente.

12. Verfahren nach einem der Ansprüche 1 bis 11, bei dem der energetische Strahl ein Strahl geladener Teilchen ist.

13. Verfahren nach Anspruch 12, bei dem der Strahl geladener Teilchen ein Elektronenstrahl ist.

## Revendications

1. Procédé de traitement d'un objet (O) comportant des structures miniaturisées, le procédé comprenant les étapes suivantes :
a) injection du gaz de réaction sur une surface de l'objet (O),
b) traitement de l'objet (O) par pointage d'un faisceau d'énergie sur un site de traitement sur la surface de l'objet (O), de manière à déposer de la matière sur l'objet ou à éliminer de la matière de l'objet (O),
c) balayage de la surface de l'objet (O) par le faisceau d'énergie et détection de produits d'interaction du faisceau d'énergie avec l'objet (O), et
d) décision quant à savoir s'il convient de poursuivre le traitement de l'objet (O) ou si celui-ci peut être interrompu à l'aide d'informations obtenues à partir des produits d'interaction détectés du faisceau d'énergie avec l'objet (O),
e) le traitement de l'objet (O) à l'étape b) étant réalisé avec un premier ensemble de paramètres faisceau du faisceau, et le balayage de la surface à l'étape c) étant réalisé avec un deuxième ensemble de paramètres faisceau du faisceau d'énergie, et le deuxième ensemble de paramètres faisceau divergeant du premier ensemble de paramètres du faisceau d'énergie,
**caractérisé en ce que**
les premier et deuxième ensembles de paramètres faisceau diffèrent l'un de l'autre au moins en ce qui concerne le temps de maintien sur pixels du faisceau à un emplacement sur la surface de l'objet (O), le temps de maintien sur pixels étant plus court à l'étape de traitement b) qu'à l'étape c).

2. Procédé selon la revendication 1, dans lequel les premier et deuxième ensembles de paramètres faisceau diffèrent l'un de l'autre de telle manière qu'au cours du traitement de l'objet (O) à l'étape b), la vitesse de traitement soit plus élevée qu'à l'étape c).

3. Procédé selon l'une des revendications 1 à 2, dans lequel les premier et deuxième ensembles de paramètres faisceau diffèrent l'un de l'autre au moins en ce qui concerne la séquence selon laquelle le faisceau frappe différents emplacements sur la surface de l'objet (O).

4. Procédé selon l'une des revendications 1 à 3, dans lequel, au cours du balayage de la surface de l'objet (O) à l'étape c), l'injection du gaz de procédé sur l'objet (O) est réduite ou interrompue.

5. Procédé selon l'une des revendications 1 à 4, dans lequel, suite à la décision à l'étape de procédé d), le traitement de l'objet (O) par pointage d'un faisceau sur un site de traitement sur la surface de l'objet (O) simultanément à l'injection de gaz de réaction se poursuit dans, et uniquement dans, les régions sur la surface de l'objet (O) où aucun traitement adéquat n'a encore été établi à l'étape de décision d).

6. Procédé selon l'une des revendications 1 à 5, dans lequel une région à traiter (107) de l'objet est subdivisée en un certain nombre de segments de surface (108, 109), et les produits d'interaction détectés lorsque le faisceau frappe des régions du même segment de surface sont intégrés pour former un signal total dans le but de déterminer s'il convient de poursuivre le traitement de l'objet (O) ou si celui-ci peut être interrompu.

7. Procédé selon la revendication 6, dans lequel les superficies des segments de surface (108, 109) diffèrent d'au plus 300%.

8. Procédé selon la revendication 6 ou 7, dans lequel seuls sont pris en compte lors de la formation du signal total les signaux qui sont détectés lorsque le faisceau incident sur l'objet (O) se situe à une distance du bord de la région à traiter (107) qui est supérieure à un espacement minimal prédéfini.

9. Procédé selon la revendication 8, dans lequel l'espacement minimal est choisi de manière à ce que le signal dû aux produits d'interaction présente pratiquement exclusivement un contraste de matière.

10. Procédé selon l'une des revendications 6 à 9, dans lequel chacun des segments de surface (108, 109) possède une dimension minimale de sorte que, sur la base de l'intégration spatiale sur les segments de surface (126) et d'une intégration temporelle parallèle sur un certain nombre de cycles d'exposition, le bruit statistique du signal détecté des produits d'interaction soit plus faible que la variation du signal détecté des produits d'interaction qui est attendue sur la base d'une variation de matière se produisant en cours de traitement.

11. Procédé selon l'une des revendications 6 à 10, dans lequel les segments de surface (108, 109) sont déterminés de manière à ce que le quotient du carré de la circonférence du segment de surface et de la superficie du segment de surface soit inférieur à 30 pour au moins 90% des segments de surface.

12. Procédé selon l'une des revendications 1 à 11, dans lequel le faisceau d'énergie est un faisceau de particules chargées.

13. Procédé selon la revendication 12, dans lequel le faisceau de particules chargées est un faisceau d'électrons.
